Europäisches Patentamt

European Patent Office

Office européen des brevets

(19)

(11) **EP 1 417 750 B1**

(12) **FASCICULE DE BREVET EUROPEEN**

(45) Date de publication et mention
de la délivrance du brevet:
**21.09.2005 Bulletin 2005/38**

(21) Numéro de dépôt: **02767588.3**

(22) Date de dépôt: **19.07.2002**

(51) Int Cl.$^7$: **H03D 7/18**, H03B 21/02

(86) Numéro de dépôt international:
**PCT/FR2002/002595**

(87) Numéro de publication internationale:
**WO 2003/017465 (27.02.2003 Gazette 2003/09)**

(54) **CIRCUIT MELANGEUR A REJECTION DE FREQUENCE IMAGE, NOTAMMENT POUR UN RECEPTEUR RF A FREQUENCE INTERMEDIAIRE NULLE OU FAIBLE**

MISCHERSCHALTUNG MIT SPIEGELFREQUENZUNTERDRÜCKUNG , UND DEREN VERWENDUNG IN EINEM DIREKTKONVERSIONSEMPFÄNGER

MIXER CIRCUIT WITH IMAGE FREQUENCY REJECTION WHICH IS INTENDED, IN PARTICULAR, FOR AN RF RECEIVER WITH ZERO OR LOW INTERMEDIATE FREQUENCY

(84) Etats contractants désignés:
**AT BE BG CH CY CZ DE DK EE ES FI FR GB GR IE IT LI LU MC NL PT SE SK TR**

(30) Priorité: **13.08.2001 FR 0110772**

(43) Date de publication de la demande:
**12.05.2004 Bulletin 2004/20**

(73) Titulaire: **Stepmind**
**92100 Boulogne-Billancourt (FR)**

(72) Inventeurs:
• **JOVENIN, Fabrice**
**F-14000 Caen (FR)**

• **CANARD, David**
**F-14000 Caen (FR)**

(74) Mandataire: **de Roquemaurel, Bruno et al**
**Novagraaf Technologies**
**122, rue Edouard Vaillant**
**92593 Levallois Perret Cedex (FR)**

(56) Documents cités:
**EP-A- 0 292 002**     **WO-A-01/15313**
**US-A- 5 410 743**     **US-A- 5 821 782**

Printed by Jouve, 75001 PARIS (FR)

**Description**

La présente invention telle qu'elle est définie dans les revendications indépendantes concerne un circuit mélangeur à l'éjection de fréquence image.

Elle s'applique notamment, mais non exclusivement, aux récepteurs radio fréquence utilisant une fréquence intermédiaire nulle ou voisine de zéro. De tels récepteurs sont utilisés en particulier dans les systèmes de téléphonie mobile tels que GSM ou DCS 1800 identique à la nonne GSM, mais fonctionnant sur une autre bande de fréquences ([1805 MHz, 1880 MHz] contre [925 MHz, 960 MHz] pour GSM). Ils sont également utilisés dans les transmissions sans fil telles que définies par les normes 802.11 a et b, Bluetooth, Hyperlan 2, et DECT (Digital European Cordless Telecommunications) ou utilisant la bande ISM à 2,4 GHz.

Un tel récepteur comprend d'une manière classique un amplificateur à faible bruit (Low Noise Amplifier) relié à l'antenne de réception, par l'intermédiaire d'un filtre passe-bande, le signal amplifié étant appliqué à un circuit mélangeur pour convertir en bande de base le signal d'entrée amplifié, ce circuit mélangeur produisant deux signaux en quadrature (déphasés de 90°) en bande de base, qui sont filtrés puis appliqués à un démodulateur.

L'avantage de tels récepteurs par rapport aux récepteurs superhétérodynes (à fréquence intermédiaire non nulle) également utilisés en téléphonie mobile, réside dans le fait qu'ils ne nécessitent pas l'usage d'un filtre externe passe-bande à ondes acoustiques de surface (SAW) qui est normalement nécessaire pour obtenir un récepteur suffisamment sélectif, un tel filtre contribuant d'une manière importante au coût, à l'encombrement et à la consommation électrique d'un tel récepteur. En contrepartie, du fait que ces récepteurs fonctionnent en bande de base, ils sont sensibles aux tensions continues engendrées par des courants de fuite se produisant notamment entre l'oscillateur local du circuit mélangeur, fonctionnant à la fréquence de la porteuse du signal reçu, et l'entrée RF du circuit de réception, et en particulier l'amplificateur faible bruit disposé en entrée de ce circuit. En outre, comme l'oscillateur local fonctionne à la même fréquence que le signal d'entrée, des interférences et interactions se produisent entre ceux-ci.

Une manière connue de résoudre le problème de courants de fuite consiste à utiliser un oscillateur local produisant un signal à une fréquence différente de celle du signal d'entrée, et qui est ensuite modifiée pour produire à un signal à la même fréquence que celle du signal d'entrée. A cet effet, on peut utiliser deux oscillateurs locaux produisant respectivement deux fréquences $F_1$ et $F_2$ différentes que l'on applique à un mélangeur simple qui produit deux signaux de fréquences respectives $F_1+F_2$ et $F_1-F_2$, $F_1$ et $F_2$ étant choisis de manière à ce que l'une des fréquences obtenues en sortie du mélangeur simple corresponde à celle du signal reçu. Il est alors nécessaire de filtrer l'autre fréquence de sortie du mélangeur simple, ce qui impose que $F_2$ soit suffisamment grande par rapport à $F_1$. Il s'avère en outre qu'un tel filtrage engendre également des problèmes d'interférence et de fuite avec le signal reçu.

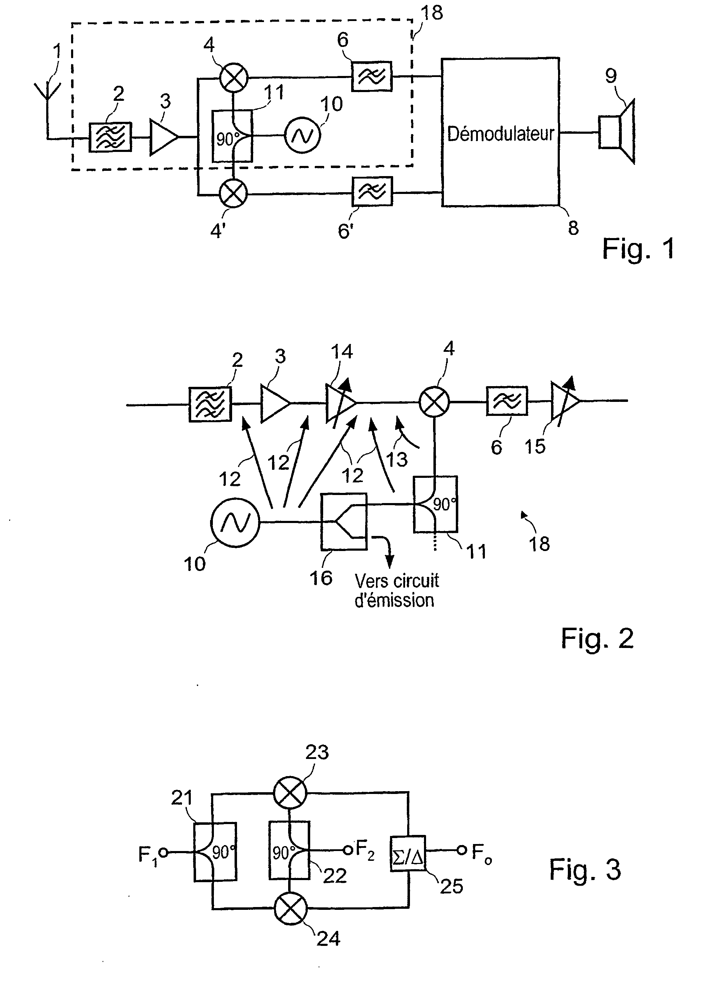

Pour résoudre ce problème, on a proposé le concept du dispositif mélangeur à réjection d'image, tel que représenté sur la Figure 3, ce dispositif utilisant deux oscillateurs locaux par exemple du type VCO (Voltage Controlled Oscillator), délivrant respectivement deux fréquences $F_1$ et $F_2$. Les sorties des oscillateurs sont reliées respectivement à deux circuits 21, 22 diviseurs de phase en quadrature fournissant chacun deux signaux en quadrature de phase, les signaux ayant la même phase en sortie des diviseurs de phase, étant appliqués à un mélangeur simple 23, 24 respectif dont la sortie est appliquée à un circuit 25 additionneur ou retrancheur délivrant un signal de sortie dont la fréquence $F_o$ est égale à $F_1-F_2$ ou $F_1+F_2$, $F_1$ et $F_2$ étant choisis de manière à $F_o$ corresponde à la fréquence du signal reçu. Toutefois, un tel dispositif dépend de la précision des diviseurs de phase. En effet, s'ils ne sont pas parfaits, le dispositif délivre également sous une forme atténuée l'autre fréquence, à savoir $F_1-F_2$ si $F_o = F_1+F_2$ ou $F_1+F_2$ si $F_o = F_1-F_2$. Le document WO-A-0 115 313 divulgue un exemple de mélangeur.

Ces dispositifs présentent en outre l'inconvénient de nécessiter deux oscillateurs locaux.

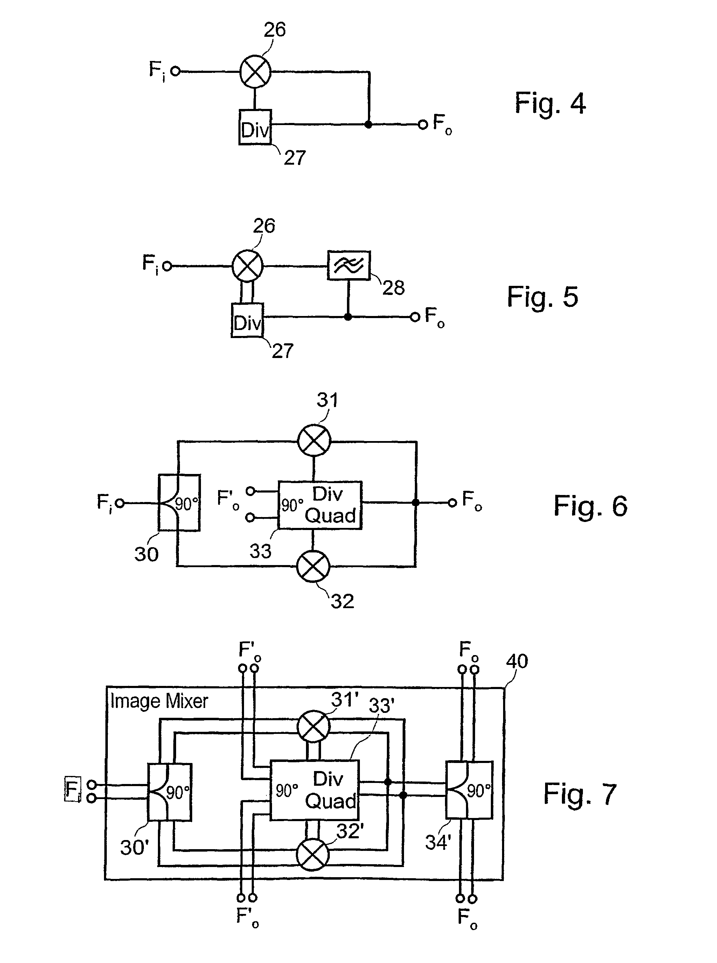

Pour supprimer l'un des deux oscillateurs locaux, on a également proposé le concept du dispositif mélangeur à régénération de fréquence. Comme représenté sur la figure 4, ce dispositif comprend un diviseur de fréquence 27 recevant en entrée le signal de sortie $F_o$ du dispositif, et un mélangeur simple 26 recevant en entrée les signaux d'entrée $F_i$ du dispositif et de sortie du diviseur de fréquence 27. Du fait de la présence du mélangeur simple 26, on a la relation suivante :

$$F_o = F_i (+ \text{et} -) \frac{F_o}{\text{Div}} \qquad (1)$$

Div étant le rapport de division du diviseur de fréquence 27.

Le signal de sortie du dispositif comprend donc deux fréquences $F_o$ valant :

$$\frac{F_i}{\left(1+\dfrac{1}{\text{Div}}\right)} \quad \text{et} \quad \frac{F_i}{\left(1-\dfrac{1}{\text{Div}}\right)} \qquad (2)$$

Pour supprimer l'une des deux fréquences, on est donc encore obligé d'utiliser un filtre passe-bas 28 (figure 5) pour éliminer la fréquence la plus basse, ce qui suppose que les deux fréquences obtenues avant filtrage soient très éloignées l'une de l'autre, et donc que le rapport de division Div soit grand. Du fait de 1a présence d'un tel filtre, ce circuit présente également les inconvénients précités dus aux interférences et interactions se produisant avec le signal d'entrée.

On a également proposé des solutions mettant en oeuvre des diviseurs de fréquence numériques. Toutefois, ces solutions sont mal adaptées à la génération de porteuses sinusoïdales.

La présente invention a pour but de supprimer ces inconvénients. Cet objectif est atteint par la prévision d'un circuit mélangeur à réjection de fréquence image comprenant un diviseur de phase en quadrature présentant une entrée reliée à l'entrée du circuit mélangeur, et deux sorties délivrant respectivement deux signaux en quadrature de phase qui sont appliqués respectivement à deux mélangeurs simples, caractérisé en ce qu'il comprend un diviseur de fréquence et de phase en quadrature ayant un rapport de division en fréquence, et présentant deux entrées connectées respectivement aux sorties respectives des deux mélangeurs simples et une première sortie délivrant un premier signal de sortie du circuit mélangeur, qui est appliqué en entrée des deux mélangeurs simples.

Avantageusement, le diviseur de fréquence et de phase en quadrature délivre sur deux autres sorties deux signaux en quadrature de phase présentant une fréquence égale à la fréquence du signal délivré par la première sortie, divisée par le rapport de division en fréquence.

Selon une particularité de l'invention, le signal issu de la première sortie du circuit mélangeur présente une fréquence égale à :

$$F_o = F_i - \frac{F_o}{\text{Div}}$$

$F_i$ étant la fréquence du signal d'entrée du circuit mélangeur, et
Div étant le rapport de division de fréquence du diviseur de fréquence et de phase.

De préférence, en vue d'être intégré dans un circuit intégré, tous ses circuits sont synétrisés pour traiter en parallèle deux signaux identiques et de polarités opposées.

Selon une autre particularité de l'invention, il comprend en outre un diviseur de phase en quadrature interposé sur sa première sortie en vue d'obtenir deux signaux de même fréquence en quadrature de phase.

Selon une autre particularité de l'invention, le rapport de division en fréquence est un nombre entier.

L'invention concerne également un récepteur RF à fréquence intermédiaire nulle ou quasi nulle comprenant un amplificateur relié à une antenne de réception, par l'intermédiaire d'un filtre passe-bande, le signal reçu par l'antenne et amplifié étant appliqué à un circuit mélangeur pour convertir en bande de base le signal d'entrée amplifié, ce circuit mélangeur étant connecté à un oscillateur local et délivrant deux signaux en quadrature (déphasés de 90°) en bande de base, qui sont filtrés puis appliqués à un démodulateur, caractérisé en ce que le circuit mélangeur comprend un mélangeur du type à réjection de fréquence image comprenant un diviseur de phase en quadrature présentant une entrée reliée à l'oscillateur local, et deux sorties délivrant respectivement deux signaux en quadrature de phase qui sont appliqués respectivement à deux mélangeurs simples, un diviseur de fréquence et de phase en quadrature ayant un rapport de division en fréquence et présentant deux entrées connectées respectivement aux sorties respectives des deux mélangeurs simples et une première sortie délivrant un premier signal de sortie qui est appliqué en entrée des deux mélangeurs simples, le premier signal de sortie étant mélangé avec le signal reçu et amplifié.

Avantageusement, le diviseur de fréquence et de phase en quadrature délivre sur deux autres sorties deux signaux en quadrature de phase présentant une fréquence égale à la fréquence du signal délivré par la première sortie, divisée par le rapport de division en fréquence.

Selon une particularité de l'invention, le récepteur RF comprend en outre un diviseur de phase en quadrature interposé sur la première sortie du mélangeur à réjection de fréquence image, en vue d'obtenir deux signaux de même fréquence en quadrature de phase.

Selon une autre particularité de l'invention, le récepteur RF comprend en outre des moyens de commutation pour appliquer respectivement aux mélangeurs simples avec le signal reçu et amplifié, soit les signaux en quadrature de phase issus de la première sortie du mélangeur à réjection de fréquence image, soit les signaux en quadrature de phase issus de la seconde sortie de celui-ci.

De préférence, pour être adapté à la réception de signaux GSM et DCS 1800, l'oscillateur local du type oscillateur commandé en tension, délivre une fréquence d'environ 2,7 GHz et le rapport de division du diviseur de fréquence et de phase en quadrature est choisi égal à 2.

Un mode de réalisation préféré du circuit selon l'invention sera décrit ci-après, à titre d'exemple non limitatif, avec référence aux dessins annexés dans lesquels

La figure 1 représente schématiquement un récepteur RF à fréquence intermédiaire nulle, selon l'art antérieur ;

La figure 2 montre plus en détail une partie du récepteur représenté sur la figure 1 ;

La figure 3 représente d'une manière schématique un circuit mélangeur à réjection de fréquence image selon l'art antérieur ;

Les figures 4 et 5 représentent d'une manière schématique des circuits mélangeurs à régénération de fréquence, selon l'art antérieur ;

Les figures 6 et 7 représentent des circuits mélangeurs à réjection de fréquence selon l'invention ;

La figure 8 montre schématiquement un récepteur RF à fréquence intermédiaire nulle, selon l'invention, dans lequel est intégré le circuit représenté sur la figure 7.

Le récepteur RF à fréquence intermédiaire nulle ou quasi nulle représenté sur la figure 1 comprend d'une manière classique un filtre passe-bande 2 connecté à l'antenne de réception 1, un amplificateur large bande et à faible bruit 3 connecté en sortie du filtre passe-bande 2, deux mélangeurs simples 4, 4' auxquels le signal de sortie de l'amplificateur est appliqué. Ces mélangeurs reçoivent également en entrée un signal issu d'un oscillateur local 10, par exemple du type VCO (Voltage Controlled Oscillator) par l'intermédiaire d'un circuit diviseur de phase en quadrature 11 qui applique aux mélangeurs 4, 4' deux signaux ayant la fréquence de l'oscillateur, mais déphasés de 90° l'un par rapport à l'autre. Dans une architecture à fréquence intermédiaire nulle, la fréquence de l'oscillateur local est choisie égale à la fréquence de la porteuse du signal à recevoir.

Les sorties respectives des deux mélangeurs simples 4, 4' sont appliquées respectivement à deux filtres passe-bas 6, 6' dont les sorties sont connectées à un démodulateur 8 en bande de base.

Dans le cas d'un téléphone mobile, le signal de sortie du démodulateur est appliqué au haut-parleur 9 du téléphone pour restituer le signal sonore transmis et reçu par le téléphone.

Comme cela est montré plus en détail sur la figure 2 qui montre une partie 18 du récepteur représenté sur la figure 1, chaque mélangeur 4, 4' est précédé d'un amplificateur 14 à gain ajustable fonctionnant dans le domaine des fréquences RF, et le filtre passe-bande 6, 6' est suivi d'un autre amplificateur 15 à gain ajustable fonctionnant dans le domaine des fréquences de la bande de base.

Par ailleurs, un dispositif de répartition 16 de signal est interposé entre l'oscillateur local 10 et le diviseur de phase 11 pour pouvoir utiliser le signal issu de l'oscillateur local dans d'autres circuits, tels que le circuit d'émission dans le cas d'un téléphone mobile.

Dans une telle architecture, il s'avère qu'il se produit un couplage et donc des courants de fuite entre l'oscillateur local 10 et une portion du circuit située entre l'entrée de l'amplificateur 3 et l'entrée de chaque mélangeur 4, 4', ainsi que des fuites entre d'une part le répartiteur 16 et le diviseur de fréquence 11, et d'autre part, la partie du circuit située entre les amplificateurs 14 et les mélangeurs 4, 4' (flèches 12 et 13). Comme la fréquence de l'oscillateur local 10 est identique à celle du signal à recevoir, ce couplage engendre un décalage en tension continue à la sortie des mélangeurs 4, 4'. Par conséquent, entre deux trains d'impulsions du signal reçu, le niveau de tension du signal d'entrée peut changer, ce qui entraîne un ajustement du gain des amplificateurs 14, 15 et donc un décalage en tension continue.

Il est connu de réduire ce décalage en tension continue à l'aide du démodulateur en bande de base 8, qui doit à cet effet déterminer ce niveau de tension continue entre chaque train d'impulsions du signal reçu, et attendre le verrouillage de l'oscillateur local et la stabilisation du niveau de tension continue dans les branches du circuit fonctionnant en bande de base.

Par ailleurs, pour réduire ces phénomènes de couplage, on a également proposé d'isoler électriquement du reste du circuit l'oscillateur local et le dispositif de répartition 16, ou bien de doubler 1a fréquence de l'oscillateur local.

Toutefois, ces solutions ne permettent pas de supprimer totalement ces phénomènes de couplage. En outre, elles contribuent à augmenter d'une manière importante la complexité, l'encombrement, la consommation électrique et le coût d'un tel circuit. En outre, dans la dernière solution envisagée, non seulement on ne supprime pas les phénomènes de couplage et d'interférence puisque l'oscillateur local interfère avec l'harmonique 2 du signal reçu, mais également, il n'est pas aisé de doubler la fréquence de l'oscillateur local lorsque le signal à recevoir présente déjà une fréquence élevée. En effet, dans les systèmes DCS 1800, il faudrait utiliser un oscillateur local à 3,6 GHz.

Pour réduire simplement et d'une manière importante les courants de couplage dans un tel circuit, l'invention propose le circuit représenté sur la figure 6, réalisant une fonction de mélangeur à réjection de fréquence image. Ce circuit comprend un diviseur de phase en quadrature 30 auquel est appliqué le signal d'entrée du circuit ayant la fréquence $F_i$, en l'occurrence le signal issu de l'oscillateur local 10. Les sorties déphasées de 90° du diviseur de phase 30 sont appliquées respectivement à deux mélangeurs simples 31, 32, tandis que l'autre entrée des mélangeurs simples reçoit le signal de sortie du circuit ayant la fréquence $F_o$. Ce circuit comprend en outre un diviseur 33 de fréquence et de phase en quadrature, comportant deux entrées reliées aux sorties respectives des deux mélangeurs simples 31, 32.

Le diviseur 33 présente également une sortie délivrant deux signaux en quadrature de phase ayant une même fréquence $F'_o$ égale à la fréquence du signal en sortie $F_o$ divisée par le rapport de division Div du diviseur 33.

Dans ce circuit, on a la relation suivante :

$$F_o = F_i - \frac{F_o}{Div} \qquad (3)$$

Cette relation permet de déduire les valeurs de $F_o$ et de $F'_o$ :

$$F_o = \frac{F_i}{\left(1 + \frac{1}{Div}\right)} = F_i \frac{Div}{Div+1} \text{ et } F'_o = \frac{F_o}{Div} = \frac{F_i}{(Div+1)} \qquad (4)$$

Il s'avère que ce circuit est parfaitement adapté à la réception de signaux GSM et DCS 1800. En effet, il suffit pour cela de choisir pour le diviseur 33 un rapport de division Div égal à 2 et une fréquence d'oscillateur local 10 égale à environ 2,7 GHz, ce qui permet d'obtenir des valeurs de $F_o$ et $F'_o$ respectivement voisines de 900 MHz et 1800 MHz. Pour les normes 802.11b, Bluetooth et DECT, on utilise par exemple un oscillateur local produisant une fréquence sensiblement égale à 3,6 GHz et un rapport de division égal à 2 de manière à obtenir une fréquence de sortie $F'_o$ voisine de 2,4 GHz. Comme la fréquence à 2,4 GHz est très utilisée, le fait d'utiliser un oscillateur local à une autre fréquence choisie dans une bande moins encombrée, permet d'éviter que l'oscillateur local soit perturbé.

Cette solution permet également de réduire d'une manière importante les phénomènes de couplage, car il n'y a plus que l'harmonique 3 du signal reçu qui interfère avec l'oscillateur local. En particulier, cette solution permet de supprimer les couplages représentés par les flèches 12 dans la figure 2.

En outre, cette solution est parfaitement adaptée à la réalisation d'un circuit intégré de réception. En effet, pour éviter les phénomènes qui se produisent dans les circuits lorsque le niveau d'intégration est élevé, les circuits sont symétrisés, c'est-à-dire doublés pour traiter les mêmes signaux mais de polarités opposées. Le circuit représenté sur la figure 7 présente une architecture analogue à celui de la figure 6, mis à part que toutes les liaisons entre les composants du circuit sont doublées, et les composants 30 à 33 du circuit sont remplacés par des composants 30' à 33' assurant la même fonction sur des signaux de polarités opposées. En outre, pour avoir un signal de sortie de fréquence $F_o$ à deux phases en quadrature, ce circuit comprend en outre un diviseur de phase en quadrature 34' auquel est appliqué ce signal de fréquence $F_o$.

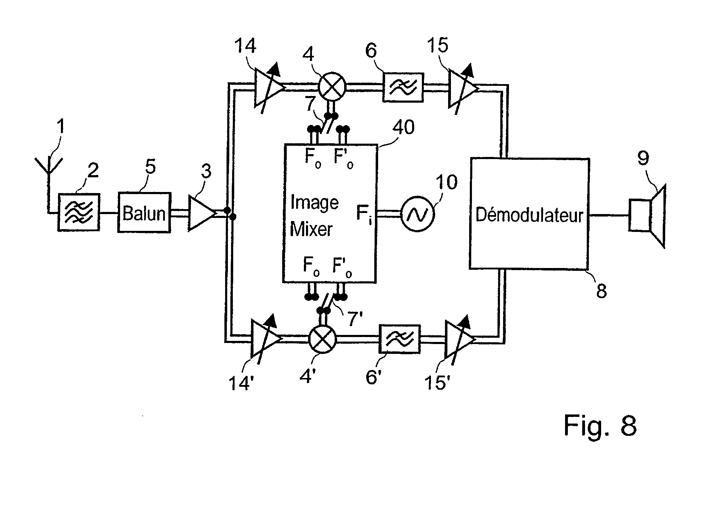

La figure 8 représente un récepteur RF intégré, à fréquence intermédiaire nulle ou quasi nulle selon l'invention. En fait, ce récepteur correspond au récepteur représenté sur les figures 1 et 2, dans lequel on a remplacé le diviseur de phase 11 par le circuit représenté sur la figure 7. Les éléments apparaissant à la fois dans cette figure et dans la figure 1 ou 2, présentent donc les mêmes numéros de référence.

En outre, ce récepteur peut comprendre un symétriseur 5 (appelé "Balun" en langue anglaise) pour générer deux signaux identiques, mais à polarités opposées, qui sont appliqués au reste du circuit qui est symétrisé pour être intégré dans un circuit intégré.

Ce récepteur peut également comprendre deux commutateurs 7, 7' disposés respectivement entre les sorties du mélangeur 40 et les entrées respectives des deux mélangeurs simples 4 et 4', permettant de sélectionner $F'_o$ (mode GSM dans l'exemple d'application à la téléphonie mobile mentionnée ci-avant) ou $F_o$ (mode DCS 1800).

**Revendications**

1. Circuit mélangeur à réjection de fréquence image comprenant un diviseur de phase en quadrature (30, 30') présentant une entrée reliée à l'entrée ($F_i$) du circuit mélangeur, et deux sorties délivrant respectivement deux signaux en quadrature de phase qui sont appliqués respectivement à deux mélangeurs simples (31, 32 ; 31'32'), **caractérisé en ce qu'**il comprend un diviseur de fréquence et de phase en quadrature (33, 33') ayant un rapport de division en fréquence, et présentant deux entrées connectées respectivement aux sorties respectives des deux mélangeurs simples (31, 32 ; 31' 32') et une première sortie délivrant un premier signal de sortie ($F_o$) du circuit mélangeur, qui est appliqué en entrée des deux mélangeurs simples.

2. Circuit mélangeur selon la revendication 1, **caractérisé en ce que** le diviseur de fréquence et de phase en quadrature (33, 33') délivre sur deux autres sorties deux signaux en quadrature de phase ($F'_o$) présentant une fréquence égale à la fréquence du signal ($F_o$) délivré par la première sortie, divisée par le rapport de division en fréquence.

3. Circuit mélangeur selon la revendication 1 ou 2, **caractérisé en ce que** le signal ($F_o$) issu de la première sortie du circuit mélangeur présente une fréquence égale à :

$$F_o = F_i - \frac{F_o}{Div}$$

   $F_i$ étant la fréquence du signal d'entrée du circuit mélangeur, et
   Div étant le rapport de division de fréquence du diviseur de fréquence et de phase (33, 33').

4. Circuit mélangeur selon l'une des revendications 1 à 3, **caractérisé en ce que**, en vue d'être intégré dans un circuit intégré, tous ses circuits sont symétrisés pour traiter en parallèle deux signaux identiques et de polarités opposées.

5. Circuit mélangeur selon l'une des revendications 1 à 4, **caractérisé en ce qu'**il comprend en outre un diviseur de phase en quadrature (34') interposé sur sa première sortie ($F_o$) en vue d'obtenir deux signaux de même fréquence en quadrature de phase.

6. Circuit mélangeur selon l'une des revendications 1 à 5, **caractérisé en ce que** le rapport de division en fréquence est un nombre entier.

7. Récepteur RF à fréquence intermédiaire nulle ou quasi nulle comprenant un amplificateur (3) relié à une antenne de réception (1), par l'intermédiaire d'un filtre passe-bande (2), le signal reçu par l'antenne et amplifié étant appliqué à un circuit mélangeur pour convertir en bande de base le signal d'entrée amplifié, ce circuit mélangeur étant connecté à un oscillateur local (10) et délivrant deux signaux en quadrature (déphasés de 90°) en bande de base, qui sont filtrés puis appliqués à un démodulateur (8), **caractérisé en ce que** le circuit mélangeur comprend un circuit mélangeur (40) du type à réjection de fréquence image comprenant un diviseur de phase en quadrature (30') présentant une entrée ($F_i$) reliée à l'oscillateur local (10), et deux sorties délivrant respectivement deux signaux en quadrature de phase qui sont appliqués respectivement à deux mélangeurs simples (31', 32'), un diviseur de fréquence et de phase en quadrature (33') ayant un rapport de division en fréquence et présentant deux entrées connectées respectivement aux sorties respectives des deux mélangeurs simples (31', 32') et une première sortie délivrant un premier signal de sortie ($F_o$) qui est appliqué en entrée des deux mélangeurs simples (31', 32'), le premier signal de sortie ($F_o$) étant mélangé avec le signal reçu et amplifié par l'intermédiaire de deux mélangeurs simples (4,4').

8. Récepteur RF selon la revendication 7, **caractérisé en ce que** le diviseur de fréquence et de phase en quadrature (33') délivre sur deux autres sorties deux signaux en quadrature de phase ($F'_o$) présentant une fréquence égale à la fréquence du signal ($F_o$) délivré par la première sortie, divisée par le rapport de division en fréquence.

9. Récepteur RF selon la revendication 7 ou 8, **caractérisé en ce que** le premier signal ($F_o$) de sortie du circuit mélangeur (40) présente une fréquence égale à :

$$F_o = F_i - \frac{F_o}{Div}$$

$F_i$ étant la fréquence du signal d'entrée du circuit mélangeur,
Div étant le rapport de division de fréquence du diviseur de fréquence et de phase.

**10.** Récepteur RF selon l'une des revendications 7 à 9,
**caractérisé en ce qu'**il comprend en outre un diviseur de phase en quadrature (34') interposé sur la première sortie ($F_o$) du circuit mélangeur à réjection de fréquence image (40), en vue d'obtenir deux signaux de même fréquence en quadrature de phase.

**11.** Récepteur RF selon la revendication 10,
**caractérisé en ce qu'**il comprend des moyens de commutation (7, 7') pour appliquer respectivement aux mélangeurs simples (4, 4') avec le signal reçu et amplifié, soit les signaux en quadrature de phase ($F_o$) issus de la première sortie du circuit mélangeur à réjection de fréquence image (40), soit les signaux en quadrature de phase ($F'_o$) issus de la seconde sortie de celui-ci.

**12.** Récepteur RF selon l'une des revendications 7 à 11,
**caractérisé en ce que** pour être adapté à la réception de signaux GSM et DCS 1800, l'oscillateur local (10), du type oscillateur commandé en tension, délivre une fréquence d'environ 2,7 GHz et le rapport de division du diviseur de fréquence et de phase en quadrature (33') est choisi égal à 2.

**13.** Récepteur RF selon l'une des revendications 7 à 10,
**caractérisé en ce que** l'oscillateur local (10), du type oscillateur commandé en tension, délivre une fréquence d'environ 3,6 GHz et le rapport de division du diviseur de fréquence et de phase en quadrature (33') est choisi égal à 2, pour obtenir une fréquence de sortie voisine de 2,4 GHz.

**Patentansprüche**

**1.** Mischerschaltung mit Spiegelfrequenzunterdrückung mit einem 90°-Phasenverschiebungsteiler (30, 30'), der einen Eingang aufweist, welcher mit dem Eingang (F) der Mischerschaltung verbunden ist, und zwei Ausgänge, die jeweils zwei um 90° phasenverschobene Signale liefern, die jeweils zu zwei einfachen Mischern (31, 32; 31', 32') gesendet werden,
**dadurch gekennzeichnet, dass** sie einen Frequenz- und 90°-Phasenverschiebungsteiler (33, 33') mit einem Frequenzteilungsverhältnis aufweist, der zwei Eingänge aufweist, die jeweils an die jeweiligen Ausgänge der beiden einfachen Mischer (31, 32; 31', 32') angeschlossen sind, und einen ersten Ausgang, der ein erstes Ausgangssignal ($F_o$) der Mischerschaltung liefert, welches zu dem Eingang der beiden einfachen Mischer gesendet wird.

**2.** Mischerschaltung gemäß Anspruch 1,
**dadurch gekennzeichnet, dass** der Frequenz- und 90°-Phasenverschiebungsteiler (33, 33') an zwei weiteren Ausgängen zwei um 90° phasenverschobene Signale ($F'_o$) liefert, welche eine Frequenz aufweisen, die gleich der Frequenz des von dem ersten Ausgang gelieferten Signals ($F_o$) ist, geteilt durch das Frequenzteilungsverhältnis.

**3.** Mischerschaltung gemäß Anspruch 1 oder 2,
**dadurch gekennzeichnet, dass** das aus dem ersten Ausgang der Mischerschaltung hervorgegangene Signal ($F_o$) eine Frequenz aufweist, die gleich:

$$F_o = F_i - \frac{F_o}{Div}$$

ist, wobei $F_i$ die Frequenz des Eingangssignals der Mischerschaltung ist, und Div das Frequenzteilungsverhältnis des Frequenz- und Phasenteilers (33, 33') ist.

**4.** Mischerschaltung gemäß einem der Ansprüche 1 bis 3,
**dadurch gekennzeichnet, dass** alle ihre Schaltungen im Hinblick auf den Einbau in eine integrierte Schaltung symmetrisch ausgebildet sind, um parallel zwei identische Signale mit entgegen gesetzten Polaritäten zu verarbeiten.

5. Mischerschaltung gemäß einem der Ansprüche 1 bis 4,
   **dadurch gekennzeichnet, dass** sie außerdem einen 90°-Phasenverschiebungsteiler (34') aufweist, der an ihrem ersten Ausgang ($F_o$) angeordnet ist im Hinblick darauf, zwei um 90° phasenverscherschobene Signale mit der gleichen Frequenz zu erhalten.

6. Mischerschaltung gemäß einem der Ansprüche 1 bis 5,
   **dadurch gekennzeichnet, dass** das Frequenzteilungsverhältnis eine ganze Zahl ist.

7. Empfänger RF mit Null oder quasi Null Zwischenfrequenz mit einem Verstärker (3), der über einen Bandpassfilter (2) mit einer Empfangsantenne (1) verbunden ist, wobei das von der Antenne empfangene und verstärkte Signal zu einer Mischerschaltung gesendet wird, um das verstärkte Eingangssignal in das Basisband zu konvertieren, wobei diese Mischerschaltung an einen lokalen Oszillator (10) angeschlossen ist und zwei um 90° versetzte (um 90° phasenverschobene) Signale in dem Basisband liefert, die gefiltert und dann zu einem Demodulator (8) gesendet werden,
   **dadurch gekennzeichnet, dass** die Mischerschaltung eine Mischerschaltung (40) der Art mit Spiegelfrequenzunterdrückung aufweist, mit einem 90°-Phasenverschiebungsteiler (30'), der einen Eingang ($F_i$) aufweist, welcher mit dem lokalen Oszillator (10) verbunden ist, und zwei Ausgänge, die jeweils zwei um 90° phasenverschobene Signale liefern, die jeweils zu zwei einfachen Mischern (31', 32') gesendet werden, einen Frequenz und 90°-Phasenverschiebungsteiler (33') mit einem Frequenzteilungsverhältnis, der zwei jeweils an die jeweiligen Ausgänge der beiden einfachen Mischer (31', 32') angeschlossene Eingänge und einen ersten Ausgang aufweist, welcher ein erstes Ausgangssignal ($F_o$) liefert, das zu dem Eingang der beiden einfachen Mischer (31', 32') gesendet wird, wobei das erste Ausgangssignal ($F_o$) mit dem empfangenen und verstärkten Signal mit Hilfe von zwei einfachen Mischern (4, 4') gemischt wird.

8. Empfänger RF gemäß Anspruch 7,
   **dadurch gekennzeichnet, dass** der Frequenz- und 90°-Phasenverschiebungsteiler (33') an zwei weiteren Ausgängen zwei um 90° phasenverschobene Signale ($F'_o$) liefert, welche eine Frequenz aufweisen, die gleich der Frequenz des von dem ersten Ausgang gelieferten Signals ($F_o$) ist, geteilt durch das Frequenzteilungsverhältnis.

9. Empfänger RF gemäß Anspruch 7 oder 8,
   **dadurch gekennzeichnet, dass** das erste Ausgangssignal ($F_o$) der Mischerschaltung (40) eine Frequenz aufweist, die gleich:

$$F_o = F_i \cdot \frac{F_o}{Div}$$

ist, wobei $F_i$ die Frequenz des Eingangssignals der Mischerschaltung ist, und Div das Frequenzteilungsverhältnis des Frequenz- und Phasenteilers (33, 33') ist.

10. Empfänger RF gemäß einem der Ansprüche 7 bis 9,
    **dadurch gekennzeichnet, dass** er außerdem einen 90°-Phasenverschiebungsteiler (34') aufweist, der an dem ersten Ausgang ($F_o$) der Mischerschaltung mit Spiegelfrequenzunterdrückung (40) angeordnet ist im Hinblick darauf, zwei um 90° phasenverscherschobene Signale mit der gleichen Frequenz zu erhalten.

11. Empfänger RF gemäß Anspruch 10,
    **dadurch gekennzeichnet, dass** er Umschaltvorrichtungen (7, 7') umfasst, um den einfachen Mischern (4, 4') jeweils mit dem empfangenen und verstärkten Signal entweder die aus dem ersten Ausgang der Mischerschaltung mit Spiegelfrequenzunterdrückung (40) stammenden, um 90° phasenverschobenen Signale ($F_o$) oder die aus deren zweitem Ausgang stammenden, um 90° phasenverschobenen Signale ($F'_o$) zu senden.

12. Empfänger RF gemäß einem der Ansprüche 7 bis 11.
    **dadurch gekennzeichnet, dass** der lokale Oszillator (10) der Art spannungsgesteuerter Oszillator zur Anpassung an den Empfang von GSM- oder DCS 1800-Signalen eine Frequenz von ungefähr 2,7 GHz liefert und das Teilungsverhältnis des Frequenz- und 90°-Phasenverschiebungsteilers (33') gleich 2 gewählt ist.

**13.** Empfänger RF gemäß einem der Ansprüche 7 bis 10,
**dadurch gekennzeichnet, dass** der lokale Oszillator (10) der Art spannungsgesteuerter Oszillator eine Frequenz von ungefähr 3.6 GHz liefert und das Teilungsverhältnis des Frequenz- und 90°-Phasenverschiebungsteilers (33') gleich 2 gewählt ist, um eine Ausgangsfrequenz nahe 2,4 GHz zu erhalten.

**Claims**

**1.** A mixer circuit with image frequency rejection, the mixer circuit comprising a quadrature phase divider (30, 30') presenting an input connected to the input ($F_i$) of the mixer circuit, and two outputs respectively delivering two signals in phase quadrature which are applied respectively to two simple mixers (31, 32; 31', 32'), the circuit being **characterized in that** it comprises a quadrature phase and frequency divider (33, 33') having a frequency division ratio and presenting two inputs respectively connected to the respective outputs of the two simple mixers (31, 32; 31', 32') and a first output delivering a first output signal ($F_o$) of the mixer circuit, which signal is applied to the inputs of the two simple mixers.

**2.** A mixer circuit according to claim 1, **characterized in that** the quadrature phase and frequency divider (33, 33') delivers on two other outputs two signals in phase quadrature ($F'_o$) presenting a frequency equal to the frequency of the signal ($F_o$) delivered by the first output as divided by the frequency division ratio.

**3.** A mixer circuit according to claim 1 or claim 2, **characterized in that** the signal ($F_o$) from the first output of the mixer circuit presents a frequency equal to:

$$F_o = F_i - \frac{F_o}{Div}$$

$F_i$ being the frequency of the input signal of the mixer circuit, and Div being the frequency division ratio of the phase and frequency divider (33, 33').

**4.** A mixer circuit according to any one of claims 1 to 3, **characterized in that** in order to be integrated in an integrated circuit, all of its circuits are made symmetrical so as to process two identical signals of opposite polarities in parallel.

**5.** A mixer circuit according to any one of claims 1 to 4, **characterized in that** it further comprises a quadrature phase divider (34') interposed on its first output ($F_o$) in order to obtain two signals at the same frequency and in phase quadrature.

**6.** A mixer circuit according to any one of claims 1 to 5, **characterized in that** the frequency division ratio is an integer.

**7.** An RF receiver of zero or quasi-zero intermediate frequency, the receiver comprising an amplifier (3) connected to a receive antenna (1) via a bandpass filter (2), the signal received by the antenna being applied, after amplification, to a mixer circuit for converting the amplified input signal to baseband, said mixer circuit being connected to a local oscillator (10) and delivering two baseband signals in quadrature (phase offset of 90°), which signals are filtered and then applied to a demodulator (8), the RF receiver being **characterized in that** the mixer circuit comprises a mixer circuit (40) of the image frequency rejection type comprising a quadrature phase divider (30') having an input ($F_i$) connected to the local oscillator (10) and two outputs respectively delivering two signals in phase quadrature which are applied respectively to two simple mixers (31', 32'), a quadrature phase and frequency divider (33') having a frequency division ratio and presenting two inputs respectively connected to the respective outputs of the two simple mixers (31', 32'), and a first output delivering a first output signal ($F_o$) which is applied to the inputs of the two simple mixers (31', 32'), the first output signal ($F_o$) being mixed with the received and amplified signal by the two simple mixers (4, 4').

**8.** An RF receiver according to claim 7, **characterized in that** the quadrature phase and frequency divider (33') delivers on two other outputs two signals in phase quadrature ($F'_o$) presenting a frequency equal to the frequency of the signal ($F_o$) delivered by the first output divided by the frequency division ratio.

**9.** An RF receiver according to claim 7 or claim 8, **characterized in that** the first output signal ($F_o$) of the mixer circuit (40) presents a frequency equal to:

$$F_o = F_i - \frac{F_o}{Div}$$

$F_i$ being the frequency of the input signal of the mixer circuit, and Div being the frequency division ratio of the phase and frequency divider.

10. An RF receiver according to any one of claims 7 to 9, **characterized in that** it further comprises a quadrature phase divider (34') interposed on the first output ($F_o$) of the image frequency rejection mixer circuit (40) in order to obtain two signals at the same frequency and in phase quadrature.

11. An RF receiver according to claim 10, **characterized in that** it includes switch means (7, 7') for applying respectively to the simple mixers (4, 4') with the received and amplified signal, either the phase quadrature signals ($F_o$) from the first output of the image frequency rejection mixer circuit (40), or the phase quadrature signals ($F'_o$) from the second output thereof.

12. An RF receiver according to any one of claims 7 to 11, **characterized in that** in order to be suitable for receiving GSM and DCS 1800 signals, the local oscillator (10) of the voltage-controlled oscillator type delivers a frequency of about 2.7 GHz and the division ratio of the quadrature phase and frequency divider (33') is selected to be equal to 2.

13. An RF receiver according to any one of claims 7 to 10, **characterized in that** the local oscillator (10) of the voltage-controlled oscillator type delivers a frequency of about 3.6 GHz, and the division ratio of the quadrature phase and frequency divider (33') is selected to be equal to 2 so as to obtain an output frequency close to 2.4 GHz.

Fig. 1

Vers circuit
d'émission

Fig. 2

Fig. 3

Fig. 4

Fig. 5

Fig. 6

Fig. 7

Fig. 8